# EUROPÄISCHE PATENTSCHRIFT

(11) **EP 2 377 377 B1**
(45) Veröffentlichungstag und Bekanntmachung des Hinweises auf die Patenterteilung: **30.04.2014**
(21) Anmeldenummer: 09764777.0
(22) Anmeldetag: 27.11.2009
(51) Int. Cl.: H05K 5/02

(54) **ÜBERDRUCKVENTIL EINES GEHÄUSES FÜR EINE ELEKTRISCHE/ELEKTRONISCHE EINHEIT**
PRESSURE-RELIEF VALVE OF A HOUSING FOR AN ELECTRICAL/ELECTRONIC UNIT
SOUPAPE DE SURPRESSION D'UN BOÎTIER POUR UNE UNITÉ ÉLECTRIQUE/ÉLECTRONIQUE

(30) Priorität: 12.12.2008 DE 102008054577
(43) Veröffentlichungstag der Anmeldung: 19.10.2011
(73) Patentinhaber: Robert Bosch GmbH, 70442 Stuttgart (DE)
(72) Erfinder: HEBACH, Andreas, 71638 Ludwigsburg (DE); KRINGS, Norman, 71636 Ludwigsburg (DE)
(86) Internationale Anmeldenummer: PCT/EP2009/065955
(87) Internationale Veröffentlichungsnummer: WO 2010/066596

(56) Entgegenhaltungen:
- EP-A1- 1 784 066
- EP-A1- 1 997 685
- EP-A2- 1 313 359
- EP-A2- 1 363 484

## Beschreibung

Die Erfindung betrifft ein Überdruckventil eines Gehäuses für eine elektrische/elektronische Einheit, mit einem Druckausgleichselement, das eine Membran aufweist.

### Stand der Technik

In Gehäuse eingeschalte elektrische und/oder elektronische Einheiten; insbesondere Steuergeräteschaltungen von Kraftfahrzeugen, müssen für einen erforderlichen Druckausgleich belüftet werden, um Funktionsbeeinträchtigungen beispielsweise durch Überdruck, Unterdruck oder durch kondensierende Luftfeuchtigkeit zu verhindern. Im Stand der Technik ist es bekannt, solche Belüftungen an Steckelementen einer Stecker-/Kabelbaum-Verbindung vorzunehmen, die an einer geschützten Stelle einen Durchtritt in das Gehäuse aufweisen. An diesen Ausführungsformen ist nachteilig, dass durch diese Durchtritte Luftfeuchtigkeit oder auch Spritzwasser in das Gehäuse eintreten kann. Hierdurch kann in ungünstigen Fällen Korrosion im Inneren des Gehäuses, insbesondere an der elektrischen oder elektronischen Einheit, auftreten. In anderen ungünstigen Fällen ist eine solche Belüftung, insbesondere durch die geringe Größe des Durchtritts der Stecker-/Kabelbaum-Verbindung, unzureichend, sodass durch ungenügende Be- und Entlüftung Schäden an der elektrischen oder elektronischen Einheit auftreten können.

Aus der EP 1 997 685 A1 ist ein Druckausgleichselement bekannt, das eine einzelne, löchrige Membran aufweist, die durch Aufbringen einer Substanz mit einer geringen Oberflächenspannung, gefolgt von Trocknung und Aushärtung, behandelt wird, um hydrophob zu wirken.

Die EP 1 363 484 A2 offenbart ebenfalls ein Druckausgleichselement, das einen luftdurchlässigen Film aufweist, der mit einer Substanz, die eine niedrige Oberflächenspannung aufweist, versehen wird, gefolgt von Trocknung und Aushärtung der Substanz, analog zu EP 1 997 685 A1.

Die EP 1 784 066 A1 offenbart eine atmungsaktive Membran, die aus einer wasserabweisenden Schicht und einer löchrigen Schicht besteht, wobei die wasserabweisende Schicht mit der löchrigen Schicht beschichtet wird.

Aus der EP 1 313 359 A2 ist ein Druckausgleichselement eines Überdruckventils bekannt, das eine Membran aufweist. Die Membran weist einen durchlässigen Membranhauptkörper auf, der beidseitig mit Stützfolien beschichtet ist. In diesem Fall ist also die Membran zwischen zwei Folien angeordnet.

Aufgabe der Erfindung ist es, ein Überdruckventil eines Gehäuses der gattungsgemäßen Art bereitzustellen, das die genannten Nachteile vermeidet und eine hinreichende Be- und Entlüftung des Gehäuses bietet, gleichzeitig aber den Zutritt von Feuchtigkeit vermeidet.

### Offenbarung der Erfindung

Hierzu wird ein Überdruckventil eines Gehäuses für eine elektrische/elektronische Einheit vorgeschlagen, insbesondere für ein Gehäuse eines Steuergeräts eines Kraftfahrzeugs, mit einem Druckausgleichselement, das eine Membran aufweist. Dabei ist vorgesehen, dass sich auf der Membran mindestens eine als Gelschicht ausgebildete hydrophobe Schicht befindet. Die hydrophobe Schicht verhindert hierbei den Durchtritt von Feuchtigkeit, und zwar sowohl in Gasphase als auch in Flüssigphase der Feuchtigkeit. Bei einem Überdruck im Gehäuse kommt es zu einer Ausbildung von Mikroporen in der hydrophoben Schicht, durch die der Überdruck abgebaut werden kann. Der hierzu notwendige Relativdruck ist von der Art und Beschaffenheit der hydrophoben Schicht abhängig und dadurch dem Einsatzzweck anpassbar; ein solcher Relativdruck liegt üblicherweise bei bekannten hydrophoben Substanzen im Bereich zwischen einem Millibar und zwanzig Millibar. Bei Unterdruck im Gehäuse erfolgt ein Druckausgleich, wie vorstehend beschrieben, wobei ein Eindringen von Feuchtigkeit durch die hydrophobe Schicht wirksam vermieden wird Die hydrophobe Schicht hat die Aufgabe, die Poren der Membran, die weiter sein können, für Flüssigkeit zu verschließen, den Zutritt oder Austritt von Gasen aus dem Gehäuse aber gleichwohl zuzulassen, insbesondere den vorstehend beschriebenen Druckausgleich zu ermöglichen.

Je in einer Ausführungsform ist vorgesehen, dass die Membran eine gelochte Kunststofffolie ist. Eine gelochte Kunststofffolie ist die prinzipiell einfachste Art einer Membran, in der nur eine Lochanordnung aus mindestens einem Loch in der Kunststofffolie vorgesehen ist. Anzahl und Anordnung solcher Lochungen in der Kunststofffolie bestimmen die Geschwindigkeit und das Volumen des möglichen Gasaustritts aus dem Gehäuse bzw. in das Gehäuse; sie bestimmen weiterhin die Art der Ausbildung von Mikroporen in der hierauf angeordneten hydrophoben Schicht. Die Lochungen der Kunststofffolie werden dann vorzugsweise so klein gewählt, dass die hydrophobe Schicht bei Druckausgleich vollständig geschlossen bleibt, ohne dass es zu einem Verlaufen der hydrophoben Schicht in beispielsweise groß geratene Löcher kommt.

In einer weiteren Ausführungsform besteht die Membran aus einer atmungsaktiven Membran oder weist eine solche auf. Atmungsaktive Membranen sind beispielsweise in Anwendungen für Bekleidung, insbesondere Funktionsbekleidung für Sportler oder Freizietaktivitäten, bekannt. Beispielsweise unter dem Namen Gore-Tex werden derartige Membranen vermarktet. Derartige Membranen sind für den beschriebenen Anwendungsbereich prinzipiell bereits gut geeignet, jedoch nicht zuverlässig wasserdicht. Insbesondere ist es bei atmungsaktiven Membranen noch möglich, dass Wasser in der Dampfphase durchtritt. Um dies zu verhindern, wird auf die Membran die hydrophobe Schicht aufgebracht. Zusammen mit den Eigenschaften der atmungsaktiven Membran, wie diese aus dem Stand der Technik bekannt ist, wird eine sehr gute Abdichtung gegen Wasser auch in Gasphase bei gleichzeitig guter Gasdurchlässigkeit zum Zwecke des Druckausgleichs erreicht.

In einer Ausführungsform ist die hydrophobe Schicht eine Ölschicht. Eine Ölschicht ist eine besonders einfache und preisgünstige Form einer hydrophoben Schicht. Im Bereich der Ölschicht wird Wasser zuverlässig abgestoßen. Die Öl-schicht ist gegebenenfalls durch Zugabe von Additiven gegen Verdampfen zu schützen bzw. in geeigneter Weise zu inaktivieren.

In einer bevorzugten Ausführungsform besteht die hydrophobe Schicht aus einer aus langkettigen, funktionalisierten Kohlenwasserstoffen bestehenden oder solche aufweisenden Schicht, insbesondere Silikonölschicht und/oder perfluorierte Ölschicht. Diese bieten eine gute Langzeitbeständigkeit und einen guten Schutz gegen Verlaufen, wobei der Dampfdruck niedrig genug ist, um einen langen Einsatz zu gewährleisten. Insbesondere ist der Dampfdruck dieser langkettigen, funktionalisierten Kohlenwasserstoffe deutlich niedriger als derjenige reiner, gängiger Öle. Besonders geeignet sind hierbei partiell polymerisierte, teilfluorierte oder silikonisierte Filme, die erfindungsgemäß Gelcharakter aufweisen, hierbei einen sehr niedrigen Dampfdruck bei dennoch ausreichendem Fließverhalten haben. Derartige Filme sind besonders vorteilhaft stabil auf der Membran anzubringen und dort über lange Zeit funktional und stabil haltbar.

In einer weiteren Ausführungsform ist vorgesehen, dass sich die hydrophobe Schicht auf beiden Seiten der Membran befindet. In dieser Ausbildung wird ein Feuchtigkeitsdurchtritt besonders zuverlässig verhindert. Insbesondere ist hierbei auch der Einsatz eines wasserbindenden Films möglich, nämlich einseitig oder alternativ beidseitig der Membran, wobei der wasserbindende Film aufgenommenes Wasser bei Erreichen einer bestimmten Temperatur, insbesondere einer Betriebstemperatur der elektrischen oder elektronischen Einheit im Gehäuse, nach außen freisetzt und sich hierdurch regeneriert.

Erfindungsgemäß ist vorgesehen, dass das Druckausgleichselement zwei Membranen aufweist, zwischen denen die hydrophobe Schicht angeordnet ist. Die hydrophobe Schicht kann hierbei eine Ölschicht, wie vorstehend beschrieben, oder aber ein wasserbindender Film sein, der aufgenommenes Wasser bei Erreichen einer bestimmten Temperatur wieder freisetzt. Weiter kann sehr vorteilhaft vorgesehen sein, sowohl eine hydrophobe Schicht als auch einen wasserbindenen Film vorzusehen, die sich in ihren Funktionen ergänzen.

Es wird weiter ein Gehäuse für eine elektrische/elektronische Einheit, insbesondere eines Steuergerätes an das Kraftfahrzeug vorgeschlagen, mit einem Überdruckventil, ausgebildet gemäß einem oder mehreren der vorstehend beschriebenen Ausführungsbeispielen.

Die Erfindung wird nachfolgend anhand von Ausführungsbeispielen näher erläutert, ohne aber hierauf beschränkt zu sein.

Es zeigen
- Figur 1: ein Gehäuse für eine elektrische/elektronische Einheit mit Druckausgleichsventil;
- Figur 2: ein Druckausgleichsventil mit zwei Membranen und einem zwischen diesen lagernden Gelfilm und
- Figur 3: ein Druckausgleichsventil mit einer Membran und einem Ölfilm.

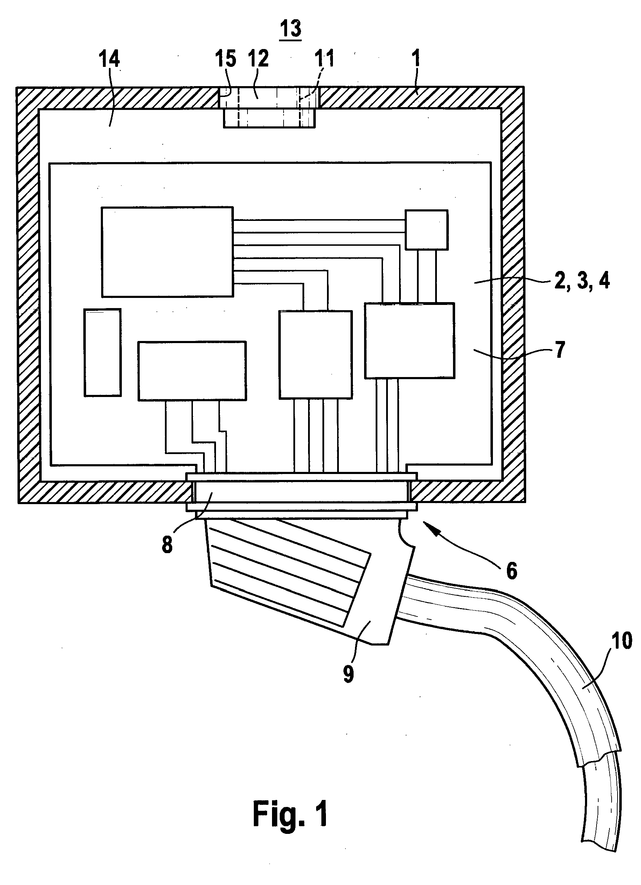

Figur 1 zeigt ein Gehäuse 1 für eine elektronische Einheit 2, nämlich eine elektronische Schaltung 3, nämlich ein Steuergerät 4 für ein nicht dargestelltes Kraftfahrzeug. Das Gehäuse 1 ist demzufolge als Steuergerätegehäuse 5 ausgebildet. Das Gehäuse 1 weist unterseitig eine Anschlusseinheit 6 auf, die aus einer an eine Leiterplatte 7 der elektronischen Schaltung 3 angeschlossene, in das Gehäuse 1 eingesetzte, insbesondere dicht eingesetzte, Messerleiste 8 und einem hiermit korrespondierenden Buchsenstecker 9 besteht, wobei der Buchsenstecker 9 ein Anschlusskabel 10 zum Anschluss an weitere, nicht dargestellte Systeme aufweist. Das Gehäuse 1 ist im geschlossenen Zustand, also beispielsweise bei aufgesetztem Deckel, hermetisch dicht. Um einen im Betrieb der elektronischen Einheit 2 erforderlichen Druckausgleich zu ermöglichen, weist das Gehäuse 1 ein Überdruckventil 11 auf, mit einem Druckausgleichselement 12, das zum Druckausgleich eine Verbindung zwischen einer Umgebung 13 des Gehäuses 1 und einem Gehäuseinnenraum 14 ermöglicht. Das Überdruckventil ist hierbei in das Gehäuse 1 eingebracht, nämlich mittels einer Gehäuseöffnung 15, die der Aufnahme des Überdruckventils 11 dient und durch das Überdruckventil 11 verschlossen wird. Die Einbringung des Überdruckventils 11 in die Gehäuseöffnung 15 erfolgt durch Clipsen, Verkleben oder bevorzugt durch Verschrauben mittels eines hier nicht separat dargestellten Gewindes.

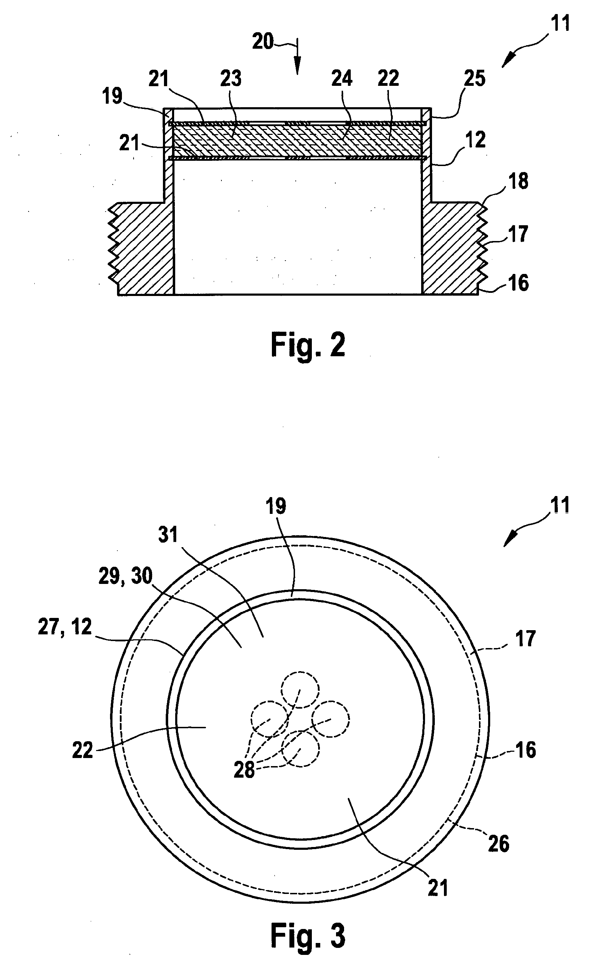

Figur 2 zeigt das Überdruckventil 11 mit dem Druckausgleichselement 12, wie in Figur 1 beschrieben. Das Überdruckventil 11 weist hierbei in einem Anschlussbereich 16 ein Außengewinde 17 auf, das mit einem nicht dargestellten Innengewinde des Gehäuses 1 (vergleiche Figur 1) korrespondiert und vorzugsweise durch Geometrie und Beschaffenheit seiner Zahnflanken 18 beim Einschrauben eines hermetische Abdichtung ergibt. Hierdurch wird sichergestellt, dass der Druckausgleich über das Druckausgleichselement 12 erfolgt, nicht aber unerwünschter Weise über Gewindegänge, über die sich Gase verschleichen könnten. Das Druckausgleichselement 12 weist innerhalb eines Ventilkörpers 19, in diesen eingebettet und zu einer Druckruchlassrichtung 20 im Wesentlichen quer angeordnet, zwei Membranen 21 auf, zwischen die eine hydrophobe Schicht 22 eingebettet ist. Die hydrophobe Schicht 22 ist hierbei bevorzugt als Gelschicht 23 ausgebildet. Diese weist bevorzugt ein partiell polymerisiertes, teilfluoriertes oder silikonisiertes, einen niedrigen Dampfdruck aufweisendes, hochviskoses Öl 24. Die Membranen 21 sind hierbei so ausgebildet, dass sie ein unerwünschtes Verfließen der hydrophoben Schicht 22 beziehungsweise ein Auslaufen aus dem vorgesehenen Bereich des Druckausgleichselements 12 vermeiden. Im einfachsten Fall besteht mindestens eine der Membranen 21 aus einer Kunststofffolie 25, die Lochungen aufweist, um einen Gasdurchtritt durch die Kunststofffolie 25 zu ermöglichen.

Figur 3 zeigt ein Überdruckventil 11 in Aufsicht ähnlich dem in Figur 2 beschriebenen, mit dem Anschlussbereich 16, der im Wesentlichen einen Schraubkörper 26 ausbildet und insbesondere das Außengewinde 17 aufweist (vergleiche Figur 2), und einem eigentlichen Ventilkörper 27, der vom Druckausgleichselement 12 gebildet wird. Im Schraubkörper 26 sind Durchtrittsöffnungen 28 eingebracht, die den Zutritt von Umgebungsluft durch den Ventilkörper 27 zum Druckausgleichselement 12 erlauben und hierbei die hier einzeln angeordnete Membran 21 sowie die hydrophobe Schicht 22 beaufschlagen. Die Membran kann beispielsweise eine Gore-Tex-Membran oder eine KunststoffMembran sein, wobei hier auf der Membran 21 ein Ölfilm 29 beziehungsweise eine Ölschicht 31 als hydrophope Schicht 22 aufgebracht ist. Der Ölfilm 29 ist eine additierte Silikonschicht 30, die aufgrund ihres niedrigen Gasdrucks stabil auf der Membran 21 lagert.

## Patentansprüche

1. Überdruckventil eines Gehäuses für eine elektrische/elektronische Einheit, insbesondere für ein Gehäuse eines Steuergeräts eines Kraftfahrzeugs, mit einem Druckausgleichselement, das mindestens eine Membran aufweist, wobei sich auf der Membran (21) mindestens eine hydrophobe Schicht (22) befindet, **dadurch gekennzeichnet, dass** das Druckausgleichselement (12) zwei Membranen (21) aufweist, zwischen denen eine als Gelschicht (23) ausgebildete hydrophobe Schicht (22) eingebettet ist.

2. Überdruckventil nach Anspruch 1, **dadurch gekennzeichnet, dass** die Membran (21) eine gelochte Kunststofffolie (25) ist.

3. Überdruckventil nach einem der vorhergehenden Ansprüche, **dadurch gekennzeichnet, dass** die jeweilige Membran (21) eine atmungsaktive Membran ist oder eine solche aufweist.

4. Überdruckventil nach einem der vorhergehenden Ansprüche, **dadurch gekennzeichnet, dass** die hydrophobe Schicht (22) eine Ölschicht (31) ist.

5. Überdruckventil nach einem der vorhergehenden Ansprüche, **dadurch gekennzeichnet, dass** die hydrophobe Schicht (22) eine aus langkettigen, funktionalisierten Kohlenwasserstoffen bestehende Schicht, insbesondere Silikonölschicht und/oder perfluorierte Ölschicht (31) ist.

6. Gehäuse (1) für eine elektrische/elektronische Einheit (2), insbesondere eines Steuergeräts (4) eines Kraftfahrzeugs, mit einem Überdruckventil (11), ausgebildet gemäß einem oder mehreren der vorhergehenden Ansprüche.

## Claims

1. Pressure-relief valve of a housing for an electrical/electronic unit, in particular for a housing of a control device of a motor vehicle, with a pressure-equalizing element which comprises at least one membrane, wherein on the membrane (21) there is at least one hydrophobic layer (22), **characterized in that** the pressure-equalizing element (12) comprises two membranes (21), between which a hydrophobic layer (22) formed as a layer of gel (23) is arranged.

2. Pressure-relief valve according to Claim 1, **characterized in that** the membrane (21) is a perforated sheet of plastic (25).

3. Pressure-relief valve according to one of the preceding claims, **characterized in that** the respective membrane (21) is a breathable membrane or comprises such a membrane.

4. Pressure-relief valve according to one of the preceding claims, **characterized in that** the hydrophobic layer (22) is a layer of oil (31).

5. Pressure-relief valve according to one of the preceding claims, **characterized in that** the hydrophobic layer (22) is a layer consisting of long-chain, functionalized hydrocarbons, in particular a layer of silicone oil and/or a layer of perfluorinated oil (31).

6. Housing (1) for an electrical/electronic unit (2), in particular of a control device (4) of a motor vehicle, with a pressure-relief valve (11), formed according to one or more of the preceding claims.

## Revendications

1. Soupape de surpression d'un boîtier pour une unité électrique/électronique, en particulier pour un boîtier d'un appareil de commande d'un véhicule automobile, comprenant un élément d'équilibrage de la pression, qui présente au moins une membrane, au moins une couche hydrophobe (22) se trouvant sur la membrane (21), **caractérisée en ce que** l'élément d'équilibrage de la pression (12) présente deux membranes (21) entre lesquelles est encastrée une couche hydrophobe (22) réalisée sous la forme d'une couche de gel (23).

2. Soupape de surpression selon la revendication 1, **caractérisée en ce que** la membrane (21) est un film en plastique perforé (25).

3. Soupape de surpression selon l'une quelconque des revendications précédentes, **caractérisée en ce que** la membrane respective (21) est une membrane respirable ou présente une telle membrane.

4. Soupape de surpression selon l'une quelconque des revendications précédentes, **caractérisée en ce que** la couche hydrophobe (22) est une couche d'huile (31).

5. Soupape de surpression selon l'une quelconque des revendications précédentes, **caractérisée en ce que** la couche hydrophobe (22) est une couche constituée d'hydrocarbures à longue chaîne, fonctionnalisés, notamment une couche d'huile de silicone et/ou une couche d'huile perfluorée (31).

6. Boîtier (1) pour une unité électrique/électronique (2), en particulier d'un appareil de commande (4) d'un véhicule automobile, comprenant une soupape de surpression (11), réalisée selon l'une quelconque ou plusieurs des revendications précédentes.
